# EUROPÄISCHE PATENTSCHRIFT

(11) **EP 1 623 884 B1**
(45) Veröffentlichungstag und Bekanntmachung des Hinweises auf die Patenterteilung: **15.04.2009**
(21) Anmeldenummer: 05014165.4
(22) Anmeldetag: 30.06.2005
(51) Int. Cl.: B60R 21/20, B60Q 5/00, C25D 5/56, H05K 3/18

(54) **Baugruppe mit Lenkrad und Gassackmodul**
Steering wheel and airbag module unit
Ensemble avec volant et module de coussin gonflable

(30) Priorität: 03.08.2004 DE 102004037462
(43) Veröffentlichungstag der Anmeldung: 08.02.2006
(73) Patentinhaber: TRW Automotive Safety Systems GmbH, 63743 Aschaffenburg (DE)
(72) Erfinder: Heil, Andreas, 63743 Aschaffenburg (DE); Schneider, Michael, Dr., 63834 Sulzbach (DE)
(74) Vertreter: Prinz & Partner

(56) Entgegenhaltungen:
- EP-A- 1 623 885
- EP-A2- 1 197 402
- WO-A-20/04039654
- DE-A1- 3 511 105
- DE-A1- 4 416 986
- DE-A1- 4 432 910
- DE-U1- 20 216 754
- DE-U1- 20 303 388

## Beschreibung

Die Erfindung betrifft eine Baugruppe mit einem Lenkrad und einem mit dem Lenkrad verbundenen Gassackmodul, wobei das Gassackmodul ein aus Kunststoff gebildetes Trägerteil zur Befestigung eines Gasgenerators umfaßt.

Gassackmodule sind ein Bestandteil von Fahrzeuginsassen-Rückhaltesystemen und können zum Schutz des Fahrers beispielsweise im Lenkrad angeordnet sein. Dabei ergeben sich aber Probleme bezüglich der räumlichen Anordnung der Kontakte für die Auslösung eines Hornsignals, da separate Betätigungshebel für den Fahrer oft unzugänglich sind und in kritischen Situationen nicht aufgefunden werden. Nach dem sogenannten "Floating Horn"-Prinzip werden die Gassackmodule daher so an dem Lenkrad angeordnet, daß durch einen von dem Fahrer ausgeübten Druck auf das Gassackmodul das Hornsignal auslösbar ist. An dem Gassackmodul und dem Lenkrad ist dabei jeweils ein Kontakt angeordnet, und das Gassackmodul ist über elastische Distanzelemente mit dem Lenkrad verbunden. Dadurch können die Kontakte bei einem auf das Gassackmodul ausgeübten Druck durch eine Bewegung des Gassackmoduls zum Lenkrad hin kurzgeschlossen und so das Horn oder ein anderes elektrisches Funktionselement ausgelöst werden.

Aus der DE 199 27 032 A1 ist eine nach diesem Prinzip arbeitende Baugruppe mit einem Lenkrad und einem Gassackmodul bekannt. Das Gassackmodul umfaßt einen im Spritzgußverfahren aus Kunststoff hergestellten Generatorträger, in den ein Drahtelement eingespritzt ist. Das Drahtelement hat bügelförmige Abschnitte, die zur elektrischen Isolation mit Kunststoffbuchsen versehen sind, und die zur Befestigung des Gassackmoduls in am Lenkrad angeordnete Rasthaken eingreifen. Der Generatorträger weist ferner eine oder mehrere Aussparungen auf, in denen das Drahtelement zugänglich und nicht elektrisch isoliert ist. In diesen Aussparungen bildet das Drahtelement einen Kontakt für die Hornauslösung, der mit einem elektrisch leitenden Gegenkontakt am Lenkrad zusammenwirkt. Wenn der Kontakt mit dem Gegenkontakt durch einen Druck auf das Gassackmodul zum Lenkrad hin kurzgeschlossen wird, wird das elektrische Horn ausgelöst.

Die EP-A2-1 197 402 zeigt ein Fahrzeuglenkrad mit einem Lenkradskelett, einer Längsachse und mit einem Gassackmodul, das mittels wenigstens einer Rastverbindung mit dem Lenkradskelett verbunden und so gelagert ist, dass es zur Betätigung der Hupe in Richtung der Längsachse verschiebbar ist. Die Rastverbindung weist zwei elektrische Kontaktflächen auf, die bei einer Verschiebung des Gassackmoduls zur Betätigung der Hupe miteinander in Kontakt kommen. Eine der Kontaktflächen ist am Kopfende eines Bolzens gebildet, der mit seinem Fußende in das Modulgehäuse eingepresst ist. Der Bolzen kann in Kunststoff ausgeführt und die Kontaktfläche mit einer Metallisierung versehen sein.

Die Erfindung schafft demgegenüber eine einfach aufgebaute und mechanisch belastbare Baugruppe mit einem Lenkrad und einem mit dem Lenkrad verbundenen Gassackmodul, wobei das Gassackmodul einen aus Kunststoff gebildeten Generatorträger zur Befestigung eines Gasgenerators umfaßt. Erfindungsgemäß ist der Generatorträger in einem vorbestimmten Bereich mit einer durch eine elektrolytische Metallabscheidung gebildeten Metallschicht in einer zur Erhöhung der Festigkeit des Generatorträgers ausreichenden Schichtdicke von zwischen 100 µm und 2 mm verstärkt, wobei die Metallschicht mindestens ein elektrisch leitendes Kontaktelement bildet. Das Kontaktelement ist Teil eines durch die Metallschicht gebildeten und auf dem Generatorträger angeordneten Leiterbahn.

Die Erfindung vereint somit die Funktionen eines elektrischen Kontakts und der mechanischen Verstärkung des Kunststoffgeneratorträgers in einem Bauteil. Damit ist es möglich, den Generatorträger mit geringeren Wandstärken zu fertigen und gleichzeitig die mechanische Belastbarkeit auch in Grenzbereichen bei hoher oder tiefer Temperatur zu gewährleisten. Der Gasgenerator kann außerdem mit einer weniger komplexen Geometrie hergestellt werden, da die Metallschichten auch die Aufgabe elektrischer Zuleitungen übernehmen und somit keine zusätzlichen Bauteile integriert werden müssen. Die Beschichtung mit Metall verbessert darüber hinaus die Hitzebeständigkeit und die mechanischen Eigenschaften des Generatorträgers. Schließlich führt die Verwendung von metallbeschichteten Kunststoffen auch zu einer Gewichtseinsparung.

Da das aus der Metallschicht gebildete elektrisch leitende Kontaktelement Teil einer auf dem Generatorträger angeordneten Leiterbahn ist, können auch die Gegenkontakte am Lenkrad variabel ausgestaltet werden. Bei diesen Gegenkontakten kann es sich um ein feststehendes Kontaktelement, z.B. einen Kontaktniet, oder einen Federkontakt handeln. Das elektrische Kontaktelement dient bevorzugt zur Auslösung eines elektrischen Hornes, indem es mit dem Gegenkontakt am Lenkrad nach dem sogenannten "Floating Horn"-Prinzip zusammenwirkt.

Des weiteren ist bevorzugt, daß der Generatorträger ein Rastelement aufweist, mit dem der Generatorträger am Lenkrad festgelegt ist. Das Rastelement kann insbesondere einen an den Generatorträger angeformten Rasthaken aus Kunststoff umfassen, der in eine entsprechende Ausnehmung im Lenkrad bzw. Lenkradskelett einschnappt. Erfindungsgemäß ist der Rasthaken ebenfalls mit einer durch eine elektrolytische Metallabscheidung gebildeten Metallschicht verstärkt. Die Metallschicht am Rasthaken und die das elektrische Kontaktelement bildende Metallschicht können in einem Verfahrensschritt aufgebracht werden. Sie können eine Funktionseinheit bilden, sind jedoch bevorzugt elektrisch voneinander isoliert. Schließlich kann auch der Gasgenerator ein Außengehäuse aus Kunststoff aufweisen, welches zur Erhöhung der Festigkeit des Gehäuses zumindest teilweise mit einer im Wege der elektrolytischen Metallabscheidung gebildeten Metallschicht verstärkt sein kann. Die elektrisch leitende Metallschicht kann besonders vorteilhaft als Kontakt für die Erdung dienen.

Die Ausbildung von verstärkenden Metallschichten auf Kunststoffen durch elektrolytische Metallabscheidung ist flexibel einsetzbar und kann auf einfache Weise zur Bildung von separaten, elektrisch voneinander isolierten Metallschichten in beliebiger Form und auf beliebigen Stellen des Generatorträgers oder sonstiger Kunststoffteile des Gassackmoduls verwendet werden. Gegenstand der Erfindung ist daher auch ein Verfahren zur Herstellung einer Baugruppe mit einem Lenkrad und einem mit dem Lenkrad verbundenen Gassackmodul gemäß Anspruch 8, bei dem die Oberfläche des Generatorträgers aus Kunststoff in einem vorbestimmten Bereich zur Erzeugung einer Oberflächenrauhigkeit vorbehandelt wird und bei dem anschließend Metall auf dem vorbehandelten Bereich unter Bildung einer haftfesten Metallschicht elektrolytisch in einer zur Erhöhung der Festigkeit des Generatorträgers ausreichenden Schichtdicke von zwischen 100 µm und 2 mm abgeschieden wird.

Die Dicke der auf den Generatorträger bzw. das Kunststoffgehäuse des Gasgenerators aufgebrachten Metallschichten richtet sich nach der zu erwartenden mechanischen Belastung der jeweiligen Bauteile und ist über die Verfahrensparameter des elektrolytischen Abscheidungsverfahrens, wie Abscheidungsdauer, Stromstärke und Elektrolytkonzentration in weiten Bereichen einstellbar. Erfindungsgemäß sind die Metallschichten zwischen 100 µm und etwa 2 mm dick. Bei Schichtdicken unterhalb von 100 µm ist keine Verbesserung der Festigkeit des Generatorträgers zu erwarten. Schichtdicken von über etwa 2 mm werden aus Kostengründen nicht zu empfehlen sein. Die elektrisch leitende Metallschicht kann auf beliebige Kunststoffe aufgebracht werden. Bevorzugt sind thermoplastische Kunststoffe, und wegen ihrer guten Festigkeitseigenschaften hier insbesondere glasfaserverstärkte oder kohlefaserverstärkte Thermoplasten.

Das Vorbehandeln der Kunststoffoberfläche umfaßt ein chemisches Ätzen und/oder ein Plasmaätzen, damit Hinterschneidungen für das mechanische Verklammern der Metallschicht auf der Kunststoffoberfläche entstehen. Anschließend wird die vorbehandelte Kunststoffoberfläche in den zur Beschichtung vorgesehenen Bereichen, beispielsweise mit kolloidem Palladium, bekeimt und zur Erzeugung einer ausreichenden elektrischen Leitfähigkeit mit einer außenstromlos abgeschiedenen Metallschicht versehen. Die Schichtdicke der außenstromlos abgeschiedenen Metallschicht kann bis zu 10 µm betragen. Die so erzeugte Metallschicht wird dann durch elektrolytische Abscheidung von Metall aus einem geeigneten Elektrolyten auf die endgültige Schichtdicke verstärkt.

Weitere Vorteile der Erfindung ergeben sich aus der nachfolgenden Beschreibung eines bevorzugten Ausführungsbeispiels unter Bezugnahme auf die Zeichnungen. In den Zeichnungen zeigen:
- Figur 1 einen Teilschnitt durch die erfindungsgemäße Baugruppe;
- Figur 2 eine Draufsicht auf die Unterseite eines Generatorträgers aus der Baugruppe gemäß Figur 1; und
- Figur 3 eine schematische Schnittansicht des Generatorträgers aus Figur 2.

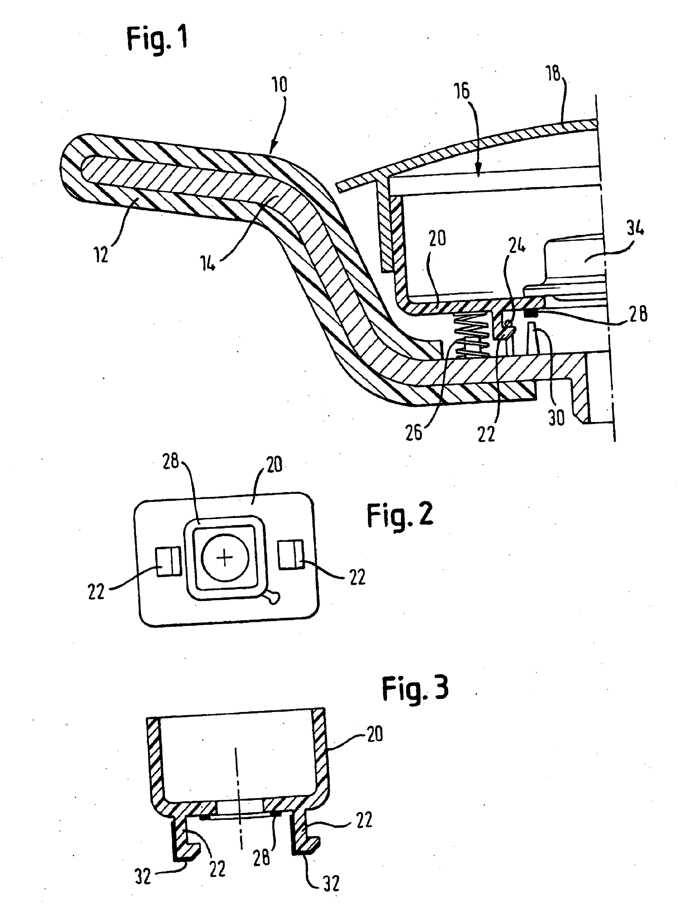

In Figur 1 ist ein Lenkrad 10 dargestellt, mit einer äußeren Verkleidung 12 aus Kunststoff und einem Lenkradskelett 14 aus Metall. Auf einem zentralen Abschnitt des Lenkradskeletts 14 ist ein Gassackmodul 16 angeordnet. Das Gassackmodul 16 umfaßt eine fahrerseitige Abdeckung 18 und einen lenkradseitig angeordneten Generatorträger 20, der in bekannter Weise im Bereich einer Seitenwand mit der Abdeckung 18 verbunden ist. Am Boden des Generatorträgers 20, der aus Kunststoff, insbesondere einem glasfaserverstärkten oder kohlefaserverstärkten Thermoplast, gebildet ist, sind ein oder mehrere Rasthaken 22 angeformt, die in ein entsprechendes Widerlager 24 am Lenkradskelett einschnappen und so den Generatorträger 20 bzw. das Gassackmodul 16 am Lenkradskelett festlegen.

Zwischen dem Boden des Generatorträgers 20 und dem Lenkradskelett 14 sind ferner ein oder mehrere elastische Distanzelemente 26, beispielsweise eine Spiralfeder, angeordnet, mit denen ein Abstand zwischen dem Lenkradskelett 14 und dem Boden des Generatorträgers 20 eingestellt wird. Darüber hinaus ist am Boden des Generatorträgers 20 ein elektrisches Kontaktelement 28 vorgesehen, welches mit einem gegenüberliegenden, am Lenkradskelett 14 angeordneten Gegenkontakt 30, beispielsweise einem Kontaktniet, zusammenwirkt.

In der Ruheposition drückt das Distanzelement 26 den Rasthaken 22 gegen das Widerlager 24, so daß das elektrische Kontaktelement 28 von dem Gegenkontakt 30 definiert beabstandet ist. Durch einen Druck auf die Abdeckung 18 in Richtung auf das Lenkrad wird das Distanzelement 26 zusammengedrückt und das elektrische Kontaktelement 28 mit dem Gegenkontakt 30 zusammengeschlossen. Dadurch kann ein elektrisches Funktionselement, beispielsweise ein elektrisches Horn, ausgelöst werden.

Das elektrische Kontaktelement 28 am Boden des Generatorträgers 20 ist durch eine elektrolytische Metallabscheidung aufgebracht. Bei der in Figur 2 dargestellten Ausführungsform ist das elektrische Kontaktelement 28 beispielsweise als Teil einer aus mehreren Leiterbahnen bestehenden gedruckten Schaltung angeführt. Hierdurch können die Gegenkontakte 30 auf dem Lenkradskelett 14 variabel plaziert werden. Die Schichtdicke des elektrischen Kontaktelements 28 und der Leiterbahnen beträgt bis zu etwa 2 mm und ist so bemessen, daß die Festigkeit des dünnwandigen Generatorträgers 20 den unter Einsatzbedingungen auftretenden Belastungen genügt.

Figur 3 zeigt, daß auch die Rasthaken 22 mit einer elektrolytisch abgeschiedenen Metallschicht 32 verstärkt sein können. Die Metallschicht 32 und das elektrische Kontaktelement 28 sind bei dieser Ausführungsform elektrisch voneinander isoliert. Die Schichtdicke des auf den Rasthaken 22 abgeschiedenen Metalls beträgt ebenfalls bis zu etwa 2 mm.

Schließlich kann auch der in Figur 1 schematisch dargestellte Gasgenerator 34 ein Außengehäuse aus Kunststoff aufweisen, welches zumindest in Teilbereichen mit einer elektrolytisch abgeschiedenen Metallschicht (hier nicht gezeigt) in einer Dicke von bis zu 2 mm verstärkt sein kann, mit der die Festigkeit des Kunststoffgehäuses erhöht wird und die zugleich die Funktion einer elektrischen Zuleitung bzw. eines Erdungskontakts übernehmen kann.

Zur Herstellung des elektrischen Kontaktelements 28 auf dem Boden des Generatorträgers 20 und ggf. der Metallschicht 32 auf den Rasthaken 22 wird die Kunststoffoberfläche des Generatorträgers 20 in den Bereichen, in denen später die elektrolytische Metallabscheidung erfolgen soll, durch chemisches Ätzen vorbehandelt, um eine ausreichende Oberflächenrauhigkeit einzustellen und Hinterschneidungen für das mechanische Verklammern der Metallschicht mit der Kunststoffoberfläche zu erzeugen. Anstelle des chemischen Ätzens kann auch ein Plasmaätzen oder eine Kombination beider Verfahren durchgeführt werden. Durch die Vorbehandlung der Oberfläche werden außerdem reaktionshemmende Oxidschichten und Verunreinigungen entfernt.

Im Anschluß an die Oberflächenvorbehandlung werden die aufgerauhten Bereiche zur Vorbereitung der elektrolytischen Metallabscheidung beispielsweise durch Eintauchen in eine Lösung von kolloidem Palladium bekeimt, gespült und in einem außenstromlosen Prozeß mit einer leitenden Metallschicht versehen. Hierzu wird die vorbehandelte und bekeimte Kunststoffoberfläche in ein Bad eingetaucht, welches sowohl ein Metallsalz als auch ein Reduktionsmittel enthält. Geeignet sind beispielsweise Kombinationen von Nickelsalzen mit Hypophosphit oder Kupfersalzen und organischen Reduktionsmitteln, wie Formaldehyd. Auf diese Weise entstehen leitfähige Metallschichten in einem gewünschten Muster mit Schichtdicken von bis zu 10 µm. Auf den nicht gerauhten und bekeimten Kunststoffoberflächen ist keine Metallabscheidung zu beobachten.

Die so erzeugten leitfähigen Metallschichten werden anschließend in einem geeigneten Elektrolyten als Kathode geschaltet und durch elektrolytische Metallabscheidung bis zur gewünschten Schichtdicke verstärkt. Auf diese Weise lassen sich verschiedene elektrisch leitende Metalle, wie beispielsweise Nickel, Kupfer, Chrom oder Silber und Kombinationen davon aufbringen. Die Gesamtschichtdicke kann bei guter Haftfestigkeit bis zu 2 mm betragen. Die in dieser Dicke vorliegenden elektrisch leitenden Metallschichten erhöhen die Festigkeit des zugrundeliegenden Kunststoffbauteils und lassen sich gleichzeitig als elektrische Kontaktelemente und Zuleitungen dafür verwenden.

## Patentansprüche

1. Baugruppe mit einem Lenkrad (10) und einem mit dem Lenkrad (10) verbundenen Gassackmodul (16), wobei das Gassackmodul (16) einen aus Kunststoff gebildeten Generatorträger (20) zur Befestigung eines Gasgenerators (34) umfaßt, **dadurch gekennzeichnet, daß** der Generatorträger (20) in einem vorbestimmten Bereich mit einer durch eine elektrolytische Metallabscheidung in einer zur Erhöhung der Festigkeit des Generatorträgers ausreichenden Schichtdicke von zwischen 100 µm und 2 mm gebildeten Metallschicht verstärkt ist und die Metallschicht mindestens ein elektrisch leitendes Kontaktelement (28) bildet, wobei die Metallschicht eine auf dem Generatorträger (20) angeordnete Leiterbahn bildet und das elektrische Kontaktelement (28) Teil der Leiterbahn ist.

2. Baugruppe nach Anspruch 1, **dadurch gekennzeichnet, daß** das elektrische Kontaktelement (28) zur Auslösung eines elektrischen Funktionselements, insbesondere eines elektrischen Hornes, mit einem Gegenkontakt (30) am Lenkrad (10) zusammenwirkt.

3. Baugruppe nach Anspruch 1 oder 2, **dadurch gekennzeichnet, daß** das elektrische Kontaktelement (28) am Boden des Generatorträgers vorgesehen ist.

4. Baugruppe nach einem der Ansprüche 1 bis 3, ferner **gekennzeichnet durch** ein am Generatorträger (20) angeordnetes Rastelement (22) aus Kunststoff, wobei das Rastelement (22) mit einer weiteren, **durch** elektrolytische Metallabscheidung gebildeten Metallschicht (32) verstärkt ist.

5. Baugruppe nach einem der Ansprüche 1 bis 4, **dadurch gekennzeichnet, daß** das Gassackmodul (16) einen Gasgenerator (34) mit einem Gehäuse aus Kunststoff umfaßt und das Kunststoffgehäuse mit einer weiteren, durch eine elektrolytische Metallabscheidung gebildeten Metallschicht verstärkt ist.

6. Baugruppe nach Anspruch 5, **dadurch gekennzeichnet, daß** die Metallschicht zwischen 100 µm und 2 mm dick ist.

7. Baugruppe nach einem der Ansprüche 1 bis 6, **dadurch gekennzeichnet, daß** der Kunststoff ein Thermoplast, insbesondere ein glasfaserverstärkter oder kohlefaserverstärkter Thermoplast, ist.

8. Verfahren zur Herstellung einer Baugruppe mit einem Lenkrad (10) und einem mit dem Lenkrad (10) verbundenen Gassackmodul (16), wobei das Gassackmodul (16) einen aus Kunststoff gebildeten Generatorträger (20) zur Befestigung eines Gasgenerators (34) umfaßt, und wobei das Verfahren die folgenden Schritte umfaßt:
Vorbehandeln einer Oberfläche des Generatorträgers (20) aus Kunststoff in einem vorbestimmten Bereich zur Erzeugung einer Oberflächenrauhigkeit, wobei das Vorbehandeln ein chemisches Ätzen und/oder Plasmaätzen umfaßt; und
elektrolytisches Abscheiden von Metall auf der vorbehandelten Oberfläche unter Bildung einer haftfesten elektrisch leitenden Metallschicht in einer zur Erhöhung der Festickeit des Generatorträgers ausreichenden Schichtdicke von zwischen 100 µm und 2 mm.

9. Verfahren nach Anspruch 8, **dadurch gekennzeichnet, daß** vor dem elektrolytischen Abscheiden von Metall eine außenstromlose Metallabscheidung durchgeführt wird.

10. Verfahren nach Anspruch 8 oder 9, **dadurch gekennzeichnet, daß** die Metallschicht mindestens ein elektrisches Kontaktelement (28) ausbildet.

11. Verfahren nach einem der Ansprüche 8 bis 10, **dadurch gekennzeichnet, daß** die Metallschicht (32) auf einem am Generatorträger (20) angeordneten Rastelement (22) abgeschieden wird.

## Claims

1. An assembly comprising a steering wheel (10) and a gas bag module (16) that is connected to the steering wheel (10), the gas bag module (16) including a generator support (20) formed of plastic for attaching a gas generator (34), **characterized in that** in a predetermined area the generator support (20) is reinforced by a metal layer formed by electroplating to a layer thickness of between 100 µm and 2 mm that is effective to increase the strength of the generator support, and that the metal layer constitutes at least one electrically conductive contact element (28), the metal layer forming a conducting track arranged on the generator support (20), and the electrical contact element (28) being part of the conducting track.

2. The assembly as recited in claim 1, **characterized in that** for activating an electrical function element, specifically an electrical horn, the electrical contact element (28) cooperates with an opposite contact (30) on the steering wheel (10).

3. The assembly as recited in claim 1 or 2, **characterized in that** the electrical contact element (28) is provided on the base of the generator support.

4. The assembly as recited in any of claims 1 to 3, further **characterized by** a latching element (22) that is made of plastic and is arranged on the generator support (20), the latching element (22) being reinforced by a further metal layer (32) formed by electroplating.

5. The assembly as recited in any of claims 1 to 4, **characterized in that** the gas bag module (16) includes a gas generator (34) having a housing made of plastic, and the plastic housing is reinforced by a further metal layer formed by electroplating.

6. The assembly as recited in claim 5, **characterized in that** the metal layer is between 100 µm and 2 mm thick.

7. The assembly as recited in any of claims 1 to 6, **characterized in that** the plastic is a thermoplastic, specifically a glass fiber reinforced or carbon fiber reinforced thermoplastic.

8. A method of manufacturing an assembly comprising a steering wheel (10) and a gas bag module (16) that is connected to the steering wheel (10), the gas bag module (16) including a generator support (20) formed of plastic for attaching a gas generator (34), and the method comprising the following steps:
pretreating a surface of the generator support (20) made of plastic in a predetermined area for generating a surface roughness, the pretreatment including a chemical etching and/or plasma etching; and
electroplating the pretreated surface to form an adherently bonded, electrically conductive metal layer to a layer thickness of between 100 µm and 2 mm that is effective for increasing the strength of the generator support.

9. The method as recited in claim 8, **characterized in that** prior to the electroplating, an electroless plating is carried out.

10. The method as recited in claim 8 or 9, **characterized in that** the metal layer forms at least one electrical contact element (28).

11. The method as recited in any of claims 8 to 10, **characterized in that** the metal layer (32) is deposited on a latching element (22) that is arranged on the generator support (20).

## Revendications

1. Ensemble comportant un volant de direction (10) et un module de coussin à gaz (16) relié au volant de direction (10), le module de coussin à gaz (16) comprenant un support de générateur (20) réalisé en matière plastique et destiné à fixer un générateur de gaz (34), **caractérisé en ce que** le support de générateur (20) est renforcé dans une zone prédéterminée par un couche métallique formée par une métallisation par électrolyse, dans une épaisseur de couche entre 100 µm et 2 mm qui est suffisante pour augmenter la solidité du support de générateur, et **en ce que** la couche métallique forme au moins un élément de contact (28) électroconducteur, la couche métallique formant une piste conductrice agencée sur le support de générateur (20), et l'élément de contact (28) électrique faisant partie de la piste conductrice.

2. Ensemble selon la revendication 1, **caractérisé en ce que** l'élément de contact (28) électrique coopère avec un contact antagoniste (30) sur le volant de direction (10) pour déclencher un élément fonctionnel électrique, en particulier un klaxon électrique.

3. Ensemble selon les revendications 1 ou 2, **caractérisé en ce que** l'élément de contact (28) électrique est prévu sur le fond du support de générateur.

4. Ensemble selon l'une des revendications 1 à 3, **caractérisé en outre par** un élément d'enclenchement (22) en matière plastique agencé sur le support de générateur (20), l'élément d'enclenchement (22) étant renforcé par une autre couche métallique (32) formée par une métallisation par électrolyse.

5. Ensemble selon l'une des revendications 1 à 4, **caractérisé en ce que** le module de coussin à gaz (16) comprend un générateur de gaz (34) avec un boîtier en matière plastique, et le boîtier de matière plastique est renforcé par une autre couche métallique formée par métallisation par électrolyse.

6. Ensemble selon la revendication 5, **caractérisé en ce que** la couche métallique a une épaisseur entre 100 µm et 2 mm.

7. Ensemble selon l'une des revendications 1 à 6, **caractérisé en ce que** la matière plastique est une matière thermoplastique, en particulier une matière thermoplastique renforcée par fibres de verre ou par fibres de carbone.

8. Procédé de fabrication d'un ensemble comportant un volant de direction (10) et un module de coussin à gaz (16) relié au volant de direction (10), le module de coussin à gaz (16) comprenant un support de générateur (20) réalisé en matière plastique pour fixer un générateur de gaz (34), et le procédé comprenant les étapes suivantes :
Traitement préalable d'une surface du support de générateur (20) en matière plastique dans une zone prédéterminée pour produire une rugosité de surface, le traitement préalable comprenant une attaque chimique et/ou une attaque par plasma ; et
métallisation par électrolyse sur la surface préalablement traitée en formant une couche métallique électroconductrice adhérente dans une épaisseur de couche entre 100 µm et 2 mm qui est suffisante pour augmenter la solidité du support de générateur.

9. Procédé selon la revendication 8, **caractérisé en ce qu'**une métallisation sans courant extérieur est effectuée avant la métallisation par électrolyse.

10. Procédé selon les revendications 8 ou 9, **caractérisé en ce que** la couche métallique forme au moins un élément de contact (28) électrique.

11. Procédé selon l'une des revendications 8 à 10, **caractérisé en ce que** la couche métallique (32) est déposée sur un élément d'enclenchement (22) agencé sur le support de générateur (20).
